# EUROPEAN PATENT APPLICATION

(11) **EP 3 189 904 A1**
(43) Date of publication of application: **12.07.2017**
(21) Application number: 17150182.8
(22) Date of filing: 03.01.2017
(51) Int. Cl.: B08B 3/02, B08B 7/00, G03F 7/42, H01L 21/67

(54) **CLEANING APPARATUS**

(30) Priority: 07.01.2016 JP 2016001751
(71) Applicant: Ebara Corporation, Ohta-ku, Tokyo 144-8510 (JP)
(72) Inventor: OZAWA, Suguru, Tokyo, 144-8510 (JP); YOKOYAMA, Toshio, Tokyo, 144-8510 (JP); TOGAWA, Tetsuji, Tokyo, 144-8510 (JP)
(74) Representative: Carstens, Dirk Wilhelm

(57) **Abstract**

Cleaning apparatus (1) provided with a heating unit (5) that heats a cleaning surface of a substrate (W), a cleaning unit (6) that supplies ozone water to the cleaning surface of the substrate (W) and cleans the cleaning surface and a control unit (7) that controls the heating of the cleaning surface and the supply of the cleaning liquid so as to clean the cleaning surface after heating the cleaning surface of the substrate (W).

## Description

### BACKGROUND OF THE INVENTION

### Field of the Invention

The present invention relates to a cleaning apparatus that supplies a cleaning liquid to a cleaning surface of a cleaning object and cleans the cleaning surface, and relates to a technique for improving cleaning effects using the cleaning liquid.

### Description of the Related Art

Conventionally, cleaning apparatuses are known which supply a cleaning liquid to a cleaning surface of a cleaning object and clean the cleaning surface. Such cleaning apparatuses are used for a process of stripping (dissolving) a resist in a manufacturing step of a flat display of a semiconductor, a liquid crystal panel or the like (e.g., see Japanese Patent Laid-Open No. 4-179225).

Conventionally, chemical solutions have been used as cleaning water in a process of stripping (dissolving) a resist, but in recent years, there is a demand for reducing the amount of chemical solutions used in consideration of the environment or the like, and use of ozone has been started instead. Ozone has the ability to dissolve organic matter and can remove a resist which is organic matter. Ozone is generally dissolved in pure water or the like and supplied to a substrate as ozone water. However, since ozone is not dissolved in pure water in a high-temperature condition (e.g., 60°C or higher, under atmospheric pressure), and it is therefore extremely difficult to provide ozone water of high concentration and high temperature. For this reason, conventional cleaning apparatuses normally use ozone water as a cleaning liquid at normal temperature.

However, in recent years, resists into which high concentration ions are implanted are often used and it has been difficult for conventional cleaning apparatuses to strip such resists. Furthermore, in recent years, there is a demand for further improvement of a resist removal rate in order to improve throughput. Therefore, there is a demand for further improvement of cleaning effects of cleaning apparatuses, and implementation of a cleaning process (resist stripping process), for example, at high temperature at which a reaction speed of a cleaning liquid (ozone water) is accelerated.

The present invention has been implemented in view of the above-described problems and it is an object of the present invention to provide a cleaning apparatus capable of improving cleaning effects using a high-temperature cleaning liquid.

### SUMMARY OF THE INVENTION

A cleaning apparatus of the present invention is provided with a heating unit that heats a cleaning surface of a cleaning object, a cleaning unit that supplies a cleaning liquid to the cleaning surface of the cleaning object and cleans the cleaning surface and a control unit that controls the heating of the cleaning surface and the supply of the cleaning liquid so as to heat the cleaning surface and then clean the cleaning surface.

According to this configuration, the control unit controls the heating of the cleaning surface and the supply of the cleaning liquid, the heating unit heats the cleaning surface, and then the cleaning unit cleans the cleaning surface. In this way, the heated cleaning surface heats up the cleaning liquid supplied to the cleaning surface, and the hot cleaning liquid improves the cleaning effect.

Furthermore, in the cleaning apparatus of the present invention, the cleaning liquid is provided by dissolving a predetermined substance in a solvent, the cleaning unit may supply the cleaning liquid to the cleaning surface at a temperature lower than a limit temperature at which the substance is not dissolved in the solvent, and the heating unit may heat the cleaning surface to a temperature higher than the limit temperature.

According to this configuration, the heating unit heats the cleaning surface to a temperature higher than a limit temperature (temperature at which the substance is not dissolved in the solvent). The cleaning liquid is supplied by the cleaning unit to the cleaning surface at a temperature lower than the limit temperature, but the cleaning liquid is supplied to the cleaning surface and then heated by the heated cleaning surface to a temperature higher than the limit temperature. By this means, the cleaning liquid supplied to the cleaning surface is heated by the heated cleaning surface to the temperature higher than the limit temperature and it is possible to obtain a high cleaning effect which would not be obtained ordinarily (cleaning liquid at a temperature lower than the limit temperature).

Furthermore, the cleaning apparatus of the present invention may be provided with a fluid curtain unit that generates a fluid curtain that covers the perimeter of the cleaning surface.

According to this configuration, the perimeter of the cleaning surface is covered with the fluid curtain, thus preventing the cleaning liquid or the like supplied to the cleaning surface from releasing to the perimeter of the cleaning surface and improving the cleaning effect by the cleaning liquid.

The cleaning apparatus of the present invention may be provided with an arm member provided with the heating unit and the cleaning unit and a drive unit that swings or translates the arm member so that the heating unit and the cleaning unit move back and forth on the cleaning surface.

According to this configuration, the drive unit causes the arm member to swing or translate, and the heating unit and the cleaning unit provided on the arm member move back and forth together on the cleaning surface. It is thereby possible to cause the heating unit to heat the cleaning surface throughout the whole cleaning surface and then cause the cleaning unit to clean the cleaning surface.

Furthermore, in the cleaning apparatus of the present invention, the drive unit may cause the arm member to swing or translate so that the cleaning unit moves on a flow line along which the heating unit moves.

According to this configuration, the drive unit causes the arm member to swing or translate and the cleaning unit moves on the flow line along which the heating unit moves. In this way, by moving the cleaning unit, it is possible to cause the cleaning unit to clean the cleaning surface after the heating unit heats the cleaning surface.

In the cleaning apparatus of the present invention, the heating unit may be disposed on the flow line along which the cleaning unit moves.

According to this configuration, the heating unit is disposed on the flow line along which the cleaning unit moves. By disposing the heating unit in this way, the cleaning unit can clean the cleaning surface after the heating unit heats the cleaning surface.

According to the present invention, the heated cleaning surface can heat up the cleaning liquid supplied to the cleaning surface and the hot cleaning liquid can improve cleaning effects.

### DETAILED DESCRIPTION OF THE DRAWINGS

FIG. 1 is a diagram describing a configuration of a cleaning apparatus according to a first embodiment of the present invention;
FIG. 2 is a diagram describing a configuration of a cleaning apparatus according to a second embodiment of the present invention;
FIG. 3 is a diagram describing a modification of the cleaning apparatus according to the second embodiment of the present invention;
FIG. 4 is a diagram describing a configuration of a cleaning apparatus according to a third embodiment of the present invention;
FIG. 5 is a diagram describing a configuration of a cleaning apparatus according to a fourth embodiment of the present invention;
FIG. 6 is a diagram describing a configuration of a cleaning apparatus according to a fifth embodiment of the present invention;
FIG. 7 is a diagram describing a configuration of a cleaning apparatus according to a sixth embodiment of the present invention; and
FIG. 8 is a diagram describing a configuration of a cleaning apparatus according to a seventh embodiment of the present invention.

### DETAILED DESCRIPTION OF THE PREFERRED EMBODIMENTS

Hereinafter, cleaning apparatuses according to embodiments of the present invention will be described with reference to the accompanying drawings. The present embodiments will illustrate cases of cleaning apparatuses used for a resist stripping process in a manufacturing step of a flat display of a semiconductor or liquid crystal panel or a substrate cleaning process with a CMP apparatus or the like.

### (First Embodiment)

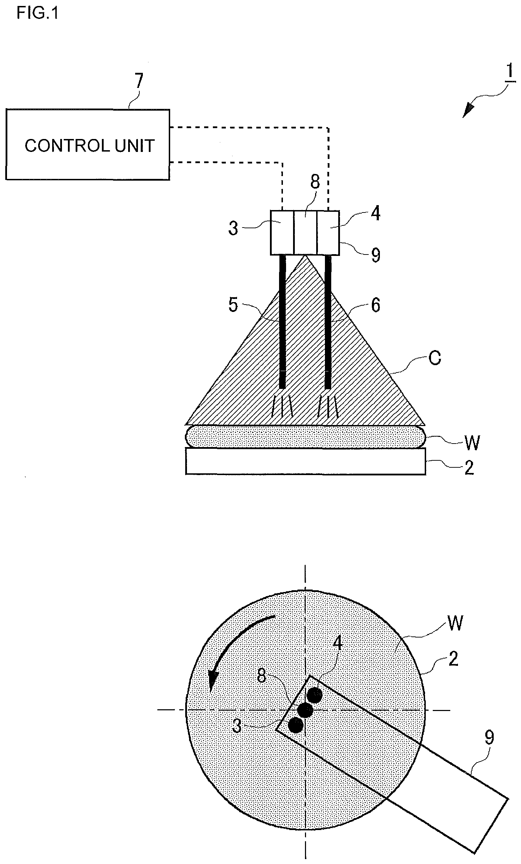

A configuration of a cleaning apparatus according to a first embodiment of the present invention will be described with reference to the accompanying drawings. FIG. 1 is a diagram describing the cleaning apparatus according to the present embodiment. As shown in FIG. 1, a cleaning apparatus 1 is provided with a turntable 2, a heating unit 3 and a cleaning unit 4. A substrate W which is a cleaning object is placed on the turntable 2. A cleaning process on the substrate W is performed while turning the substrate W by the turntable 2. The heating unit 3 is provided with a heating nozzle 5 that jets steam to heat the cleaning surface of the substrate W. The cleaning unit 4 is provided with a cleaning nozzle 6 that supplies ozone water which is a cleaning liquid to the cleaning surface of the substrate W and cleans the cleaning surface.

The heating unit 3 and the cleaning unit 4 are connected to the control unit 7. The control unit 7 controls the heating of the cleaning surface and the supply of ozone water so that the cleaning surface is heated and then the cleaning surface is cleaned. In the present embodiment, the control unit 7 controls timing of jetting steam from the heating nozzle 5 and timing of supplying ozone water from the cleaning nozzle 6 so as to heat the cleaning surface and then clean the cleaning surface. That is, when a cleaning process on the substrate W starts, the control unit 7 controls timing of the heating of the cleaning surface and the supply of the ozone water so as to jet steam from the heating nozzle 5 and then supply the ozone water from the cleaning nozzle 6.

In the present embodiment, the cleaning apparatus 1 is provided with a fluid curtain unit 8 that generates a fluid curtain C that covers the perimeter of the cleaning surface of the substrate W. Examples of the fluid curtain C include water curtain or air curtain. The fluid curtain C prevents the steam jetted from the heating nozzle 5 or the ozone water supplied from the cleaning nozzle 6 from being released to the perimeter (outside) of the cleaning surface of the substrate W. The heating unit 3, the cleaning unit 4 and the fluid curtain unit 8 are provided on an arm member 9.

The ozone water which is a cleaning liquid is provided by dissolving ozone in pure water. Ozone is substantially not dissolved in pure water at a temperature higher than a predetermined limit temperature (60°C under an atmospheric pressure). In the present embodiment, the cleaning unit 4 supplies ozone water to the cleaning surface at a temperature lower than this limit temperature. Therefore, it is possible to supply to the cleaning surface, high concentration ozone water in which ozone is sufficiently dissolved. The heating unit 3 heats the cleaning surface to a temperature higher than the limit temperature. For example, the heating unit 3 heats the cleaning surface up to a temperature higher than the limit temperature by jetting to the cleaning surface, steam at a temperature higher than the limit temperature (e.g., steam at 150°C) from the heating nozzle 5. The ozone water supplied to the cleaning surface is heated by the cleaning surface up to a temperature higher than the limit temperature. Note that hot water (e.g., hot water at 80°C) at a temperature higher than the limit temperature may be jetted from the heating nozzle 5.

In the present embodiment, steam is jetted from the heating nozzle 5 to the center of the substrate W placed on the turntable 2 and the ozone water is supplied from the cleaning nozzle 6. In this case, as the turntable 2 turns, the steam (or boiling water) supplied from the heating nozzle 5 or the ozone water supplied from the cleaning nozzle 6 is spread from the center of the substrate W toward the edge by a centrifugal force, allowing the entire substrate W to be cleaned.

According to the cleaning apparatus 1 of the first embodiment, the control unit 7 controls the heating of the cleaning surface of the substrate W and the supply of ozone water, the heating unit 3 heats the cleaning surface and then the cleaning unit 4 cleans the cleaning surface. Thus, the heated cleaning surface of the substrate W can heat up the ozone water supplied to the cleaning surface and improve cleaning effects with high temperature ozone water.

In this case, the heating unit 3 heats the cleaning surface to a temperature (e.g., 150°C) higher than the limit temperature (temperature at which ozone is not dissolved in pure water, for example, 60°C). The ozone water is supplied to the cleaning surface by the cleaning unit 4 at a temperature lower than the limit temperature, but after being supplied to the cleaning surface, the ozone water is heated by the heated cleaning surface to a temperature higher than the limit temperature. In this way, the ozone water supplied to the cleaning surface is heated by the heated cleaning surface up to a temperature higher than the limit temperature, and it is possible to obtain a high cleaning effect which would not be obtained ordinarily (ozone water at a temperature lower than the limit temperature).

Furthermore, in the present embodiment, the perimeter of the cleaning surface is covered with the fluid curtain C (e.g., water curtain) and it is possible to prevent the ozone water or the like supplied to the cleaning surface from being released to the perimeter of the cleaning surface and improve the cleaning effect by the ozone water.

### (Second Embodiment)

Next, the cleaning apparatus 1 according to a second embodiment of the present invention will be described. Here, aspects of the cleaning apparatus 1 of the second embodiment which are different from those of the first embodiment will be mainly described. Here, a configuration and operation of the present embodiment are similar to those of the first embodiment unless specifically mentioned.

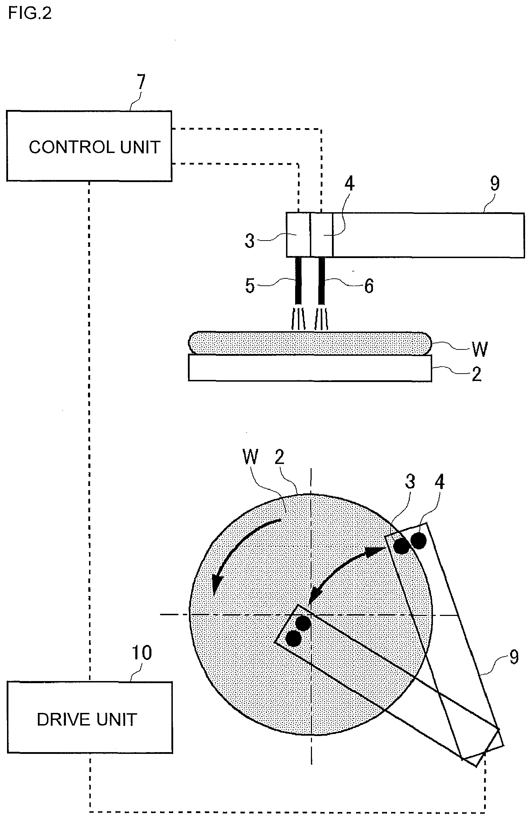

FIG. 2 is a diagram describing a configuration of the cleaning apparatus 1 of the present embodiment. As shown in FIG. 2, in the present embodiment, the cleaning apparatus 1 is provided with a drive unit 10 and the drive unit 10 is configured to cause the arm member 9 to swing. Note that the operation of the drive unit 10 is controlled by the control unit 7. In this case, the arm member 9 swings so that the heating unit 3 and the cleaning unit 4 move back and forth on the cleaning surface. From the standpoint of movement of the cleaning unit 4, it can be said that the arm member 9 swings so that the cleaning unit 4 moves on a flow line along which the heating unit 3 has moved. On the other hand, from the standpoint of the arrangement of the heating unit 3, it can be said that the heating unit 3 is disposed on the flow line along which the cleaning unit 4 moves.

Such a cleaning apparatus 1 of the second embodiment can also achieve operations and effects similar to those of the first embodiment. In addition, in the present embodiment, the drive unit 10 causes the arm member 9 to swing, and the heating unit 3 and the cleaning unit 4 provided in the arm member 9 move back and forth together on the cleaning surface. It is thereby possible to clean the cleaning surface by the cleaning unit 4 after heating the cleaning surface by the heating unit 3.

Furthermore, in the present embodiment, the drive unit 10 causes the arm member 9 to swing and the cleaning unit 4 moves on the flow line along which the heating unit 3 has moved. By moving the cleaning unit 4 in this way, it is possible to clean the cleaning surface by the cleaning unit 4 after heating the cleaning surface by the heating unit 3.

Furthermore, in the present embodiment, the heating unit 3 is disposed on the flow line along which the cleaning unit 4 moves. By disposing the heating unit 3 in this way, it is possible to clean the cleaning surface by the cleaning unit 4 after heating the cleaning surface by the heating unit 3.

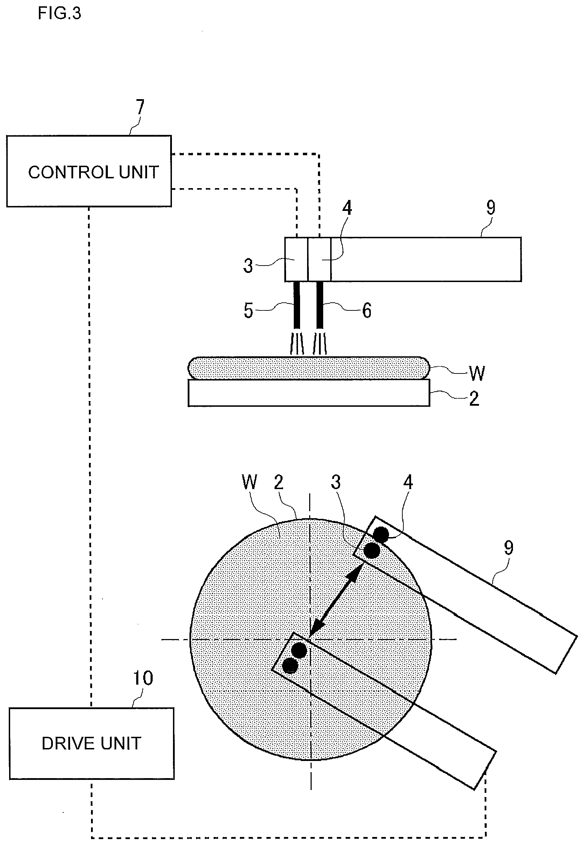

FIG. 3 shows a modification of the cleaning apparatus 1 of the second embodiment. In this modification, the drive unit 10 is configured so as to translate the arm member 9. In this case, the arm member 9 translates such that the heating unit 3 and the cleaning unit 4 move back and forth on the cleaning surface. From the standpoint of the movement of the cleaning unit 4, it can also be said that the arm member 9 translates such that the cleaning unit 4 moves on the flow line along which the heating unit 3 has moved. Such a modification also achieves operations and effects similar to those of the second embodiment.

### (Third Embodiment)

Next, the cleaning apparatus 1 according to a third embodiment of the present invention will be described. Here, aspects of the cleaning apparatus 1 of the third embodiment which are different from the second embodiment will be mainly described. Here, a configuration and operation of the present embodiment are similar to those of the second embodiment unless specifically mentioned.

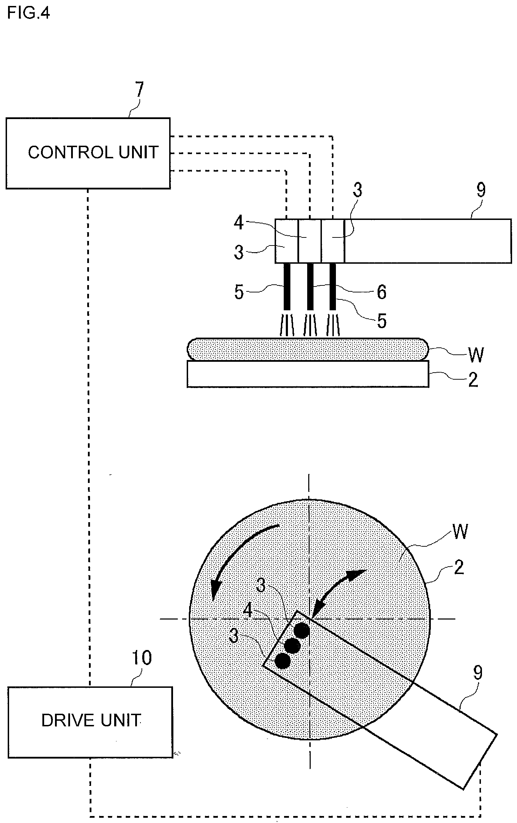

FIG. 4 is a diagram describing a configuration of the cleaning apparatus 1 of the present embodiment. As shown in FIG. 4, in the present embodiment, the heating units 3 are provided on both sides of the cleaning unit 4. The arm member 9 swings such that the heating units 3 and the cleaning unit 4 move back and forth on the cleaning surface in this case, too. From the standpoint of an arrangement of the heating units 3, it can also be said that the heating units 3 are arranged on both sides of the flow line along which the cleaning unit 4 moves.

Such a cleaning apparatus 1 of the third embodiment can also achieve operations and effects similar to those of the second embodiment. In addition, in the present embodiment, since the heating units 3 are provided on both sides of the cleaning unit 4, the heating function of the cleaning surface by the heating unit 3, that is, the heating function of ozone water improves.

### (Fourth Embodiment)

Next, the cleaning apparatus 1 according to a fourth embodiment of the present invention will be described. Here, aspects of the cleaning apparatus 1 of the fourth embodiment which are different from the second embodiment will be mainly described. Here, a configuration and operation of the present embodiment are similar to those of the second embodiment unless specifically mentioned.

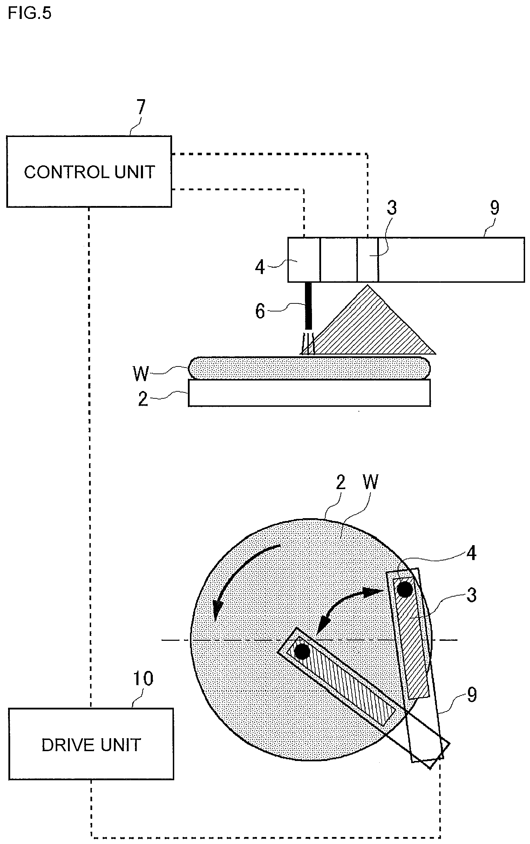

FIG. 5 is a diagram describing a configuration of the cleaning apparatus 1 according to the present embodiment. As shown in FIG. 5, in the present embodiment, the heating range of the heating unit 3 is expanded. The heating unit 3 can heat a wide range and the heating unit 3 can heat, for example, a range of length from the center of the substrate W to an end (range corresponding to a radius of the substrate W).

Such a cleaning apparatus 1 of the fourth embodiment can also achieve operations and effects similar to those of the second embodiment. In addition, since the heating range of the heating unit 3 is expanded in the present embodiment, a heating function of the cleaning surface by the heating unit 3, that is, the heating function of ozone water improves.

### (Fifth Embodiment)

Next, the cleaning apparatus 1 according to a fifth embodiment of the present invention will be described. Here, aspects of the cleaning apparatus 1 of the fifth embodiment which are different from the fourth embodiment will be mainly described. Here, a configuration and operation of the present embodiment are similar to those of the fourth embodiment unless specifically mentioned.

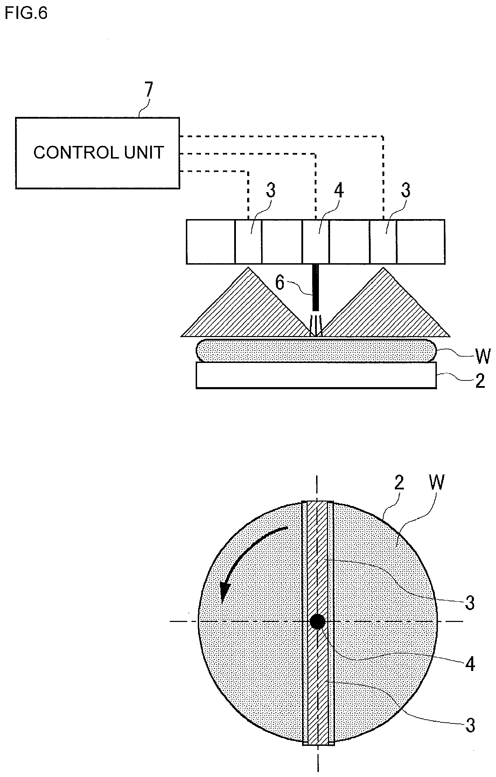

FIG. 6 is a diagram describing a configuration of the cleaning apparatus 1 of the present embodiment. As shown in FIG. 6, in the present embodiment, the heating range of the heating unit 3 is further expanded. This heating unit 3 can heat a still wider range and can heat, for example, a range of length from one end to the other end of the substrate W (range corresponding to the diameter of the substrate W).

Such a cleaning apparatus 1 of the fifth embodiment can also achieve operations and effects similar to those of the fourth embodiment. In addition, in the present embodiment, since the heating range of the heating units 3 is further expanded, the heating function of the cleaning surface by the heating unit 3, that is, the heating function of ozone water improves.

### (Sixth Embodiment)

Next, the cleaning apparatus 1 according to a sixth embodiment of the present invention will be described. Here, aspects of the cleaning apparatus 1 of the sixth embodiment which are different from the second embodiment will be mainly described. Here, a configuration and operation of the present embodiment are similar to those of the second embodiment unless specifically mentioned.

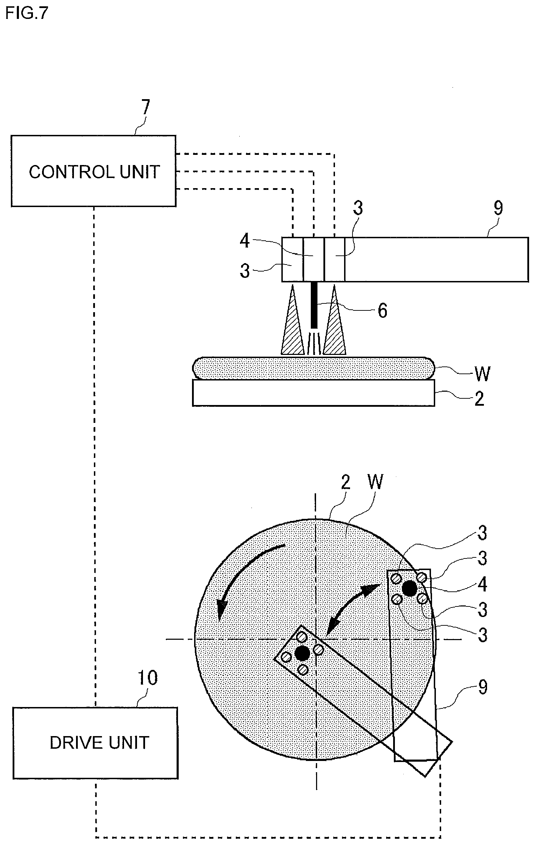

FIG. 7 is a diagram describing a configuration of the cleaning apparatus 1 according to the present embodiment. As shown in FIG. 7, in the present embodiment, the heating units 3 are provided in four corners surrounding the cleaning unit 4. The heating range of the heating units 3 is thereby expanded.

Such a cleaning apparatus 1 of the sixth embodiment can also achieve operations and effects similar to those of the second embodiment. In addition, since the heating range of the heating units 3 is expanded in the present embodiment, the heating function of the cleaning surface by the heating units 3, that is, the heating function of ozone water improves.

### (Seventh Embodiment)

Next, the cleaning apparatus 1 according to a seventh embodiment of the present invention will be described. Here, aspects of the cleaning apparatus 1 of the seventh embodiment which are different from the first embodiment will be mainly described. Here, a configuration and operation of the present embodiment are similar to those of the first embodiment unless specifically mentioned.

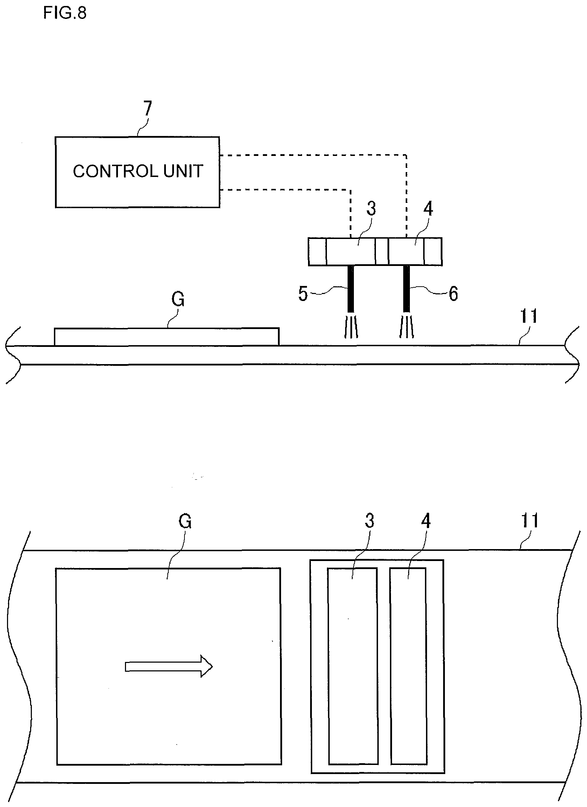

FIG. 8 is a diagram describing a configuration of the cleaning apparatus 1 of the present embodiment. As shown in FIG. 8, in the present embodiment, the cleaning apparatus 1 is provided with a belt conveyor type table 11, the heating unit 3, and the cleaning unit 4. A liquid crystal glass G which is a cleaning object is placed on the belt conveyor type table 11. A cleaning process on the liquid crystal glass G is performed while translating the liquid crystal glass G by the belt conveyor type table 11.

In the present embodiment, the heating unit 3 is disposed on an upstream side (left side in FIG. 8) and the cleaning unit 4 is disposed on a downstream side (right side in FIG. 8). Therefore, the liquid crystal glass G passes under the heating unit 3 and then passes under the cleaning unit 4. That is, the cleaning process is performed so as to clean the cleaning surface after heating the cleaning surface.

Such a cleaning apparatus 1 of the seventh embodiment can also achieve operations and effects similar to those of the first embodiment. In the present embodiment, it is possible to perform a cleaning process on the liquid crystal glass G.

The embodiments of the present invention have been described with examples and illustrations so far, but the scope of the present invention is not limited to these embodiments, and can be changed or modified according to a purpose within the scope described in claims.

For example, although a case has been described above where ozone water is used as the cleaning liquid, a chemical solution other than ozone water can also be used as the cleaning liquid. Furthermore, although the heating unit 3 that heats the cleaning surface of the substrate W by jetting steam has been illustrated above, the cleaning surface of the substrate W may be heated using a heater built in the turntable 2.

As described above, the cleaning apparatus according to the present invention has an effect of being able to improve cleaning effects using a hot cleaning liquid and is suitable for use in a resist stripping process in a manufacturing step of a flat display such as a semiconductor or liquid crystal panel or a substrate cleaning process with a CMP apparatus.
- 1: Cleaning apparatus
- 2: Turntable
- 3: Heating unit
- 4: Cleaning unit
- 5: Heating nozzle
- 6: Cleaning nozzle
- 7: Control unit
- 8: Fluid curtain unit
- 9: Arm member
- 10: Drive unit
- 11: Belt conveyor type table
- W: Substrate
- G: Liquid crystal glass

## Claims

1. A cleaning apparatus (1) comprising:
a heating unit (3) that heats a cleaning surface of a cleaning object; and
a cleaning unit (4) that supplies a cleaning liquid to the cleaning surface of the cleaning object and cleans the cleaning surface,
**characterized in that** the cleaning apparatus (1) comprises a control unit (7) that controls the heating of the cleaning surface and the supply of the cleaning liquid so as to heat the cleaning surface and then clean the cleaning surface.

2. The cleaning apparatus (1) according to claim 1, wherein the cleaning liquid is provided by dissolving a predetermined substance in a solvent,
the cleaning unit (4) supplies the cleaning liquid to the cleaning surface at a temperature lower than a limit temperature at which the substance is not dissolved in the solvent, and
the heating unit (3) heats the cleaning surface to a temperature higher than the limit temperature.

3. The cleaning apparatus (1) according to claim 1 or 2, further comprising a fluid curtain unit (8) that generates a fluid curtain that covers the perimeter of the cleaning surface.

4. The cleaning apparatus (1) according to any of claims 1 to 3, further comprising:
an arm member (9) provided with the heating unit (3) and the cleaning unit (4); and
a drive unit (10) that swings or translates the arm member (9) so that the heating unit (3) and the cleaning unit (4) move back and forth on the cleaning surface.

5. The cleaning apparatus (1) according to claim 4, wherein the drive unit (10) swings or translates the arm member (9) so that the cleaning unit (4) moves on a flow line along which the heating unit (3) moves.

6. The cleaning apparatus (1) according to claim 4 or 5, wherein the heating unit (3) is disposed on a flow line along which the cleaning unit (4) moves.
